# EUROPEAN PATENT APPLICATION

(11) **EP 2 081 231 A2**
(43) Date of publication of application: **22.07.2009**
(21) Application number: 09000236.1
(22) Date of filing: 09.01.2009
(51) Int. Cl.: H01L 29/78, H01L 29/739, H01L 29/10, H01L 29/36, H01L 21/336, H01L 29/423

(54) **Semiconductor device with an extended base region**

(30) Priority: 15.01.2008 JP 2008005992; 14.08.2008 JP 2008208896; 29.09.2008 JP 2008249557
(71) Applicant: Yokogawa Electric Corporation, Tokyo 180-8750 (JP)
(72) Inventor: Komachi, Tomonori, Musashino-shi Tokyo 180-8750 (JP)
(74) Representative: Grünecker, Kinkeldey, Stockmair & Schwanhäusser Anwaltssozietät

(57) **Abstract**

A semiconductor device according to the present invention includes: a first region (11) having a first conductive type; a plurality of second regions (17) having a second conductive type that differs from the first conductive type, and arranged in the first region; a plurality of third regions (19) having the first conductive type and formed in the second regions; an electrode (12) for forming a channel between the first region and the third region; and a plurality of extended second regions (20) having the second conductive type, arranged in the first region (11) such as to individually include one of the second regions (17) and having an impurity density that is lower than an impunity density of the second regions (17). In embodiments an extended second region (113) extends between the first region (101) and the second regions (102) so as to fully cover said first region (101).

## Description

### BACKGROUND OF THE INVENTION

### Field of the Invention

The present invention relates to a semiconductor device that can be applied in a metal oxide semiconductor field effect transistor (MOSFET) having a vertical structure, an insulated gate bipolar transistor (IGBT), a diode, and the like.

Priority is claimed on Japanese Patent Application No. 2008-005992, filed January 15, 2008, Japanese Patent Application No. 2008-208896, filed August 14, 2008, and Japanese Patent Application No. 2008-249557, filed September 29, 2008, the contents of which are incorporated herein by reference.

The invention of the present application relates to inventions disclosed in Japanese Patent Application No. 2007-170732, and Japanese Patent Application No. 2008-103732, which are filed by the applicant of the present application.

### Description of Related Art

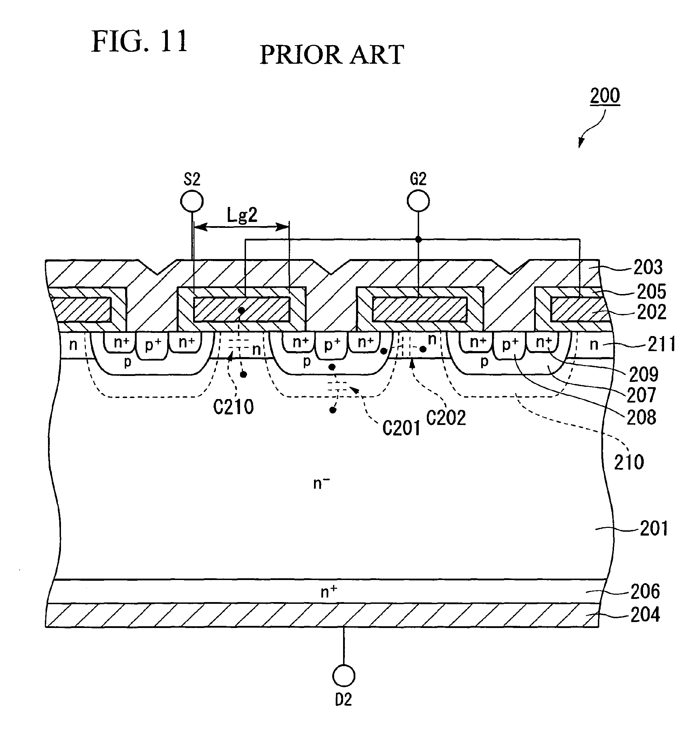

Conventional power MOSFETs and solid state relays (SSR) are constituted with a semiconductor device known as a vertical double-diffused MOSFET (DMOSFET). FIG 11 is a cross-sectional view showing the configuration of a conventional vertical double-diffused MOSFET. As shown in FIG 11, a conventional double-diffused MOSFET 200 includes a gate electrode 202 and a source electrode 203, which are provided on a top face side of an n⁻ drift layer 201 formed from n-type silicon. The double-diffused MOSFET 200 also includes a drain electrode 204, which is provided on a bottom face side of the n⁻ drift layer 201. The double-diffused MOSFET 200 includes a source terminal S2, a gate terminal G2, and a drain terminal D2.

In FIG. 11, a layer designated by symbol 'n' has electrons as its majority carrier. A layer designated by symbol 'p' has holes as its majority carrier. Symbol'+' appended to the symbols 'n' and 'p' indicates that the layer has comparatively high impurity-density, while symbol '-' indicates that the layer has comparatively low impurity-density.

The gate electrode 202 is made of, for example, polysilicon. A plurality of these gate electrodes 202 are arranged at predetermined intervals along the n⁻ drift layer 201. An oxide film 205 is formed around each gate electrode 202 such as to enclose it. The source electrode 203 is formed such as to cover the gate electrode 202 with the oxide film 205 therebetween and fill a gap between the gate electrodes 202. The drain electrode 204 is provided on the bottom face side of the n⁻ drift layer 201 with an n⁺ layer 206 therebetween.

On the top face side of the n⁻ drift layer 201, a p base layer 207 is formed by diffusing impurities using the gap between the gate electrodes 202. By re-using the gap between the gate electrodes 202 to diffuse impurities, a p⁺ layer 208 and an n⁺ layer 209 are formed in the p base layer 207. A depletion layer 210 is formed between the p base layer 207 and the n⁻ drift layer 201. An n layer 211 is provided below the gate electrode 202 and between the p base layers 207, and prevents increase in the resistance due to a junction field-effect transistor (JFET) when DMOSFET 200 is in an on-state.

In this configuration, when no voltage is applied to the gate electrode 202, current will not flow between the source electrode 203 and the drain electrode 204 unless a positive voltage is applied to the source electrode 203. In contrast, when a voltage is applied to the gate electrode 202, an n-channel is created in the p base layer 207. Consequently, when a voltage is applied between the source electrode 203 and the drain electrode 204, current flows along a route leading, for example, from the source electrode 203, via the n⁺ layer 209, the n-channel formed in the p base layer 207, the n layer 211, the n⁻ drift layer 201, the n⁺ layer 206, to the drain electrode 204.

For details of another conventional semiconductor device in addition to the one shown in FIG 11, see for example Japanese Patent Application, First Publication No. H07-221296.

The drain-source capacitance C_{ds} and the drain-gate capacitance C_{dg} are examples of important characteristics of a semiconductor device that performs switching; preferably, both are low in order to realize high-speed switching. In the semiconductor device 200 shown in FIG 11, the drain-source capacitance C_{ds} is largely determined by the sum of a junction capacitance C201 between the p base layer 207 and the n⁻ drift layer 201, and a junction capacitance C202 between the p base layer 207 and the n layer 211. The drain-gate capacitance C_{dg} is largely determined by a capacitance C210 via the oxide film 205 between the gate electrode 202 and the n layer 211.

By adjusting the density of the n⁻ drift layer 201, it is possible to reduce the parasitic capacitance (the drain-source capacitance C_{ds}). However, the breakdown voltage and on-resistance of the semiconductor device 200 shown in FIG. 11 are determined by the density and thickness of the n⁻ drift layer 201. Therefore, if the density of the n⁻ drift layer 201 is adjusted to reduce the parasitic capacitance, there is a danger that the breakdown voltage, the on-resistance, and the like of the semiconductor device 200 will change, reducing its performance.

### SUMMARY OF THE INVENTION

The present invention has been realized in consideration of the above points. It is an object of the invention to provide a semiconductor device that can reduce parasitic capacitance without greatly affecting the breakdown voltage and the on-resistance.

According to the invention, since a semiconductor device includes a plurality of extended second regions that individually include one of a plurality of second regions, a depletion layer can be made wider than when the extended second regions are not provided. Parasitic capacitance can therefore be reduced without greatly affecting the breakdown voltage and the on-resistance.

Furthermore, according to an embodiment of the invention, an oxide film is formed between the second regions and isolates adjacent second regions, and electrode is formed on the oxide film. Therefore, the electrode and the first region can be separated from each other, whereby parasitic capacitance can be reduced.

Moreover, according to the embodiment of the invention, each of a plurality of the electrodes corresponds with each of the third regions and is formed only near each of the third regions. This can reduce the plan-view overlap between the electrodes and the first region, and further reduce parasitic capacitance.

Further, according to an embodiment of the invention, it is possible to provide a semiconductor device with a high breakdown voltage and low on-resistance, which suppresses drain-source capacitance and drain-gate capacitance.

Further, according to the embodiment of the invention, it is possible to provide a semiconductor device which is ideal for industrial measuring equipment, has low capacitance, a high breakdown voltage, low on-resistance, low loss, and is fast, small, and inexpensive.

### BRIEF DESCRIPTION OF THE DRAWINGS

FIG 1 is a cross-sectional view showing a schematic configuration of a semiconductor device according to a first embodiment of the invention.
FIG 2 is a cross-sectional view showing a schematic configuration of a semiconductor device according to a second embodiment of the invention.
FIG 3 is a cross-sectional view showing a schematic configuration of a semiconductor device according to a third embodiment of the invention.
FIG 4 is a cross-sectional view showing a schematic configuration of a semiconductor device according to a fourth embodiment of the invention.
FIG 5 is a cross-sectional view showing the semiconductor device shown in FIG 4 in a conductive state.
FIG 6 is a cross-sectional view showing a schematic configuration of a semiconductor device according to a fifth embodiment of the invention.
FIG 7 is a cross-sectional view showing a schematic configuration of a semiconductor device according to a sixth embodiment of the invention.
FIG 8 is a cross-sectional view showing the semiconductor device shown in FIG 7 in a conductive state.
FIGS. 9A to 9C are step diagrams of a manufacturing method of the semiconductor device shown in FIG 7.
FIG 10 is a cross-sectional view showing a schematic configuration of a semiconductor device according to a seventh embodiment of the invention.
FIG 11 is a cross-sectional view showing a configuration of a conventional vertical DMOSFET.

### DETAILED DESCRIPTION OF THE INVENTION

Semiconductor devices according to embodiments of the invention will be explained in detail with reference to the drawings. The explanation that follows describes an example where the semiconductor devices have the structure of a vertical double-diffused MOSFET.

### (First Embodiment)

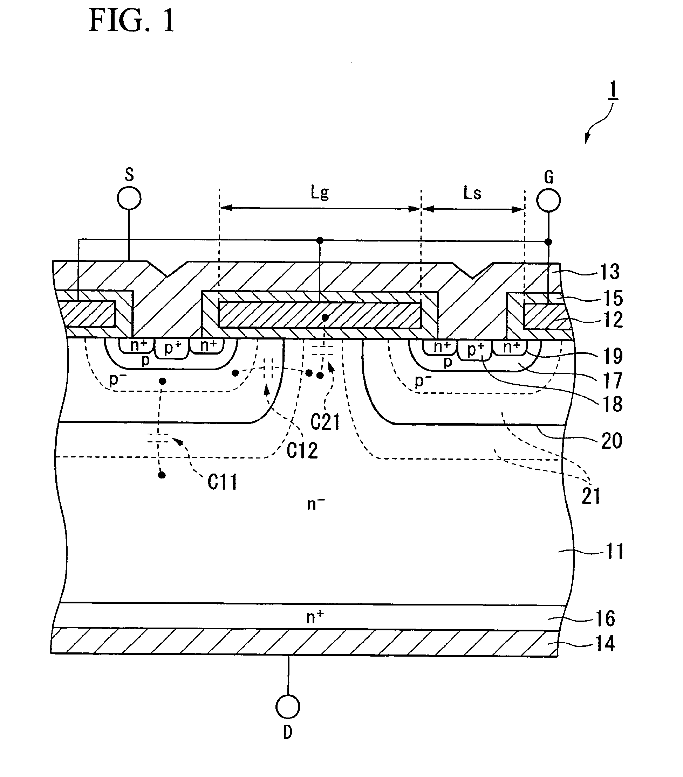

FIG. 1 is a cross-sectional view showing a schematic configuration of a semiconductor device according to a first embodiment of the invention. As shown in FIG 1, a semiconductor device 1 of this embodiment includes a gate electrode (electrode) 12 and a source electrode 13, which are provided on a top face side of a substrate (e.g. n-type silicon) whereon an n⁻ drift layer (first region) 11 and the like are formed, and a drain electrode 14 which is provided on a bottom face side of the n⁻ drift layer 11. The semiconductor device 1 has a source terminal S, a gate terminal G, and a drain terminal D.

In FIG 1, a layer designated by symbol 'n' has electrons as its majority carrier (first conductive layer). A layer designated by symbol 'p' has holes as its majority carrier (second conductive layer). Symbol'+' appended to the symbols 'n' and 'p' indicates that the layer has comparatively high impurity-density, while symbol '-' indicates that the layer has comparatively low impurity-density.

The gate electrode 12 is made of, for example, polysilicon. A plurality of these gate electrodes 202 are arranged at predetermined intervals along substrate top face where the n⁻ drift layer 11 and the like are formed. An oxide film 15 of SiO₂ or the like is formed around each gate electrode 12 such as to enclose it. The source electrode 13 is formed such as to cover the gate electrode 12 with the oxide film 15 therebetween, and to embed a gap between the gate electrodes 12. The drain electrode 14 is provided on the bottom face side of the substrate where the n⁻ drift layer 11 and the like are formed, with an n⁺ layer 16 therebetween.

On the top face side of the substrate where the n⁻ drift layer 11 and the like are formed, a p base layer (second region) 17 is formed by diffusing impurities using the gap between the gate electrodes 12. By re-using the gap between the gate electrodes 12 to diffuse impurities, a p⁺ layer 18 and an n⁺ layer (third region) 19 are formed in the p base layer 17. The p base layer 17 is preferably shallow, so that it does not restrict the width of a depletion layer 21 formed in an extended p base layer 20 described later. The length Lg of the gate electrode 12 is the length from the n⁺ layer 19 formed on one of adjacent p base layers 17 to the n⁺ layer 19 formed on the other p base layer 17. The length Lg of the gate electrode 12 is required to be sufficient to enable formation of a depletion layer 21 having a sufficient width, and to ensure that there is no reduction in resistance when the semiconductor device 1 is in an on-state.

An extended p base layer 20 (extended second region) is formed such as to individually contain the p base layer 17. The impurity density of the extended p base layer 20 is set lower than that of the p base layer 17. This extended p base layer 20 is provided in order to reduce the drain-source capacitance C_{ds} of the semiconductor device 1. As will be explained in detail later, since the extended p base layer 20 is formed by diffusing low-density impurities into the n⁻ drift layer 11 having low impurity-density, the internal state of the extended p base layer 20 is almost intrinsic. Consequently, the depletion layer 21 is formed not only in the n⁻ drift layer 11, but also in the extended p base layer 20. As a result, the depletion layer 21 formed between the extended p base layer 20 and the n⁻ drift layer 11 is increased. This greatly reduces the junction capacitance C11 between the extended p base layer 20 and the n⁻ drift layer 11.

This embodiment does not include the n layer 111 for preventing an increase in on-resistance caused by parasitic JFET that is included in the conventional vertical DMOSFET 200 shown in FIG 11. Therefore, the depletion layer 21 is further increased, reducing the junction capacitance C12 between the extended p base layer 20 and the n⁻ drift layer 11 (corresponding to the junction capacitance C202 in FIG 11). Thus in the semiconductor device 1 of this embodiment, the drain-source capacitance C_{ds} is greatly reduced without affecting the breakdown voltage and on-resistance. As shown in FIG 1, in the semiconductor device 1 of this embodiment, the length Lg of the gate electrode 12 is greater than the length Ls of the source electrode. Consequently, the semiconductor device 1 is appropriate for use as a high breakdown voltage device in which the increase in the length Lg of the gate electrode 12 does not greatly affect the on-resistance.

### (Second Embodiment)

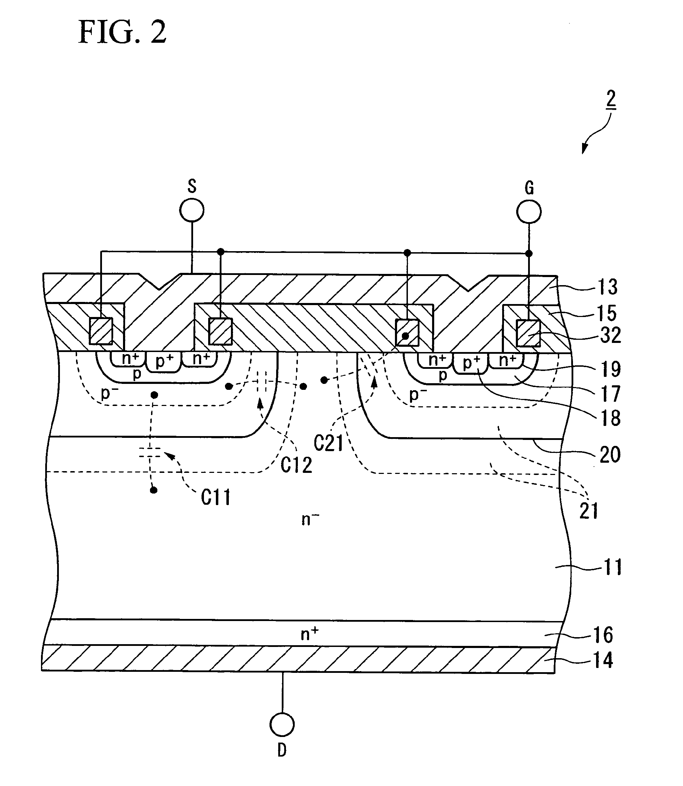

FIG 2 is a cross-sectional view showing a schematic configuration of a semiconductor device according to a second embodiment of the invention. As shown in FIG 2, while the configuration is roughly similar to that of the semiconductor device 1 in FIG 1, one difference is the inclusion of a gate electrode 32 having a structure that differs from that of the gate electrode 12. The semiconductor device 1 shown in FIG 1 includes the gate electrode 12 whose length is the length from the n⁺ layer 19 formed on one of adjacent p base layers 17 to the n⁺ layer 19 formed on the other p base layer 17. In contrast, the semiconductor device 2 of the embodiment shown in FIG 2 includes a gate electrode 32 with an opening above a portion where the n⁻ drift layer 11 is exposed at the surface (intermediary portion between adjacent p base layers 17).

Inclusion of the gate electrode 32 having the structure shown in FIG. 2 reduces the plan-view overlap between the n⁻ drift layer 11 and the gate electrode 32. This makes it possible to greatly reduce the drain-gate capacitance C_{dg}, which is largely determined by a capacitance C21 via an oxide film 15 between the n⁻ drift layer 11 and the gate electrode 32. Here it is preferable that, in addition to the opening which is provided above the portion where the n⁻ drift layer 11 is exposed at the surface, an opening is also provided above the extended p base layer 20, and that the gate electrode 32 is only formed near each of the n⁺ layers 19 in correspondence with them. The reason for this is that, since the impurity density of the extended p base layer 20 is low and an inversion layer is already formed, no bias is required.

As described above, the semiconductor device 2 according to this embodiment includes the gate electrode 32 with an opening above the portion where the n⁻ drift layer 11 is exposed at the surface, or with the opening above that portion and an opening above the extended p base layer 20. Therefore, the drain-gate capacitance C_{dg} can be greatly reduced. Also in this embodiment, as in the first embodiment, the extended p base layer 20 is formed around the p base layer 17. Therefore, the drain-source capacitance C_{ds} can be greatly reduced. Thus in this embodiment, the drain-gate capacitance C_{dg} and the drain-source capacitance C_{ds} can be greatly reduced, whereby parasitic capacitance can be greatly reduced.

### (Third Embodiment)

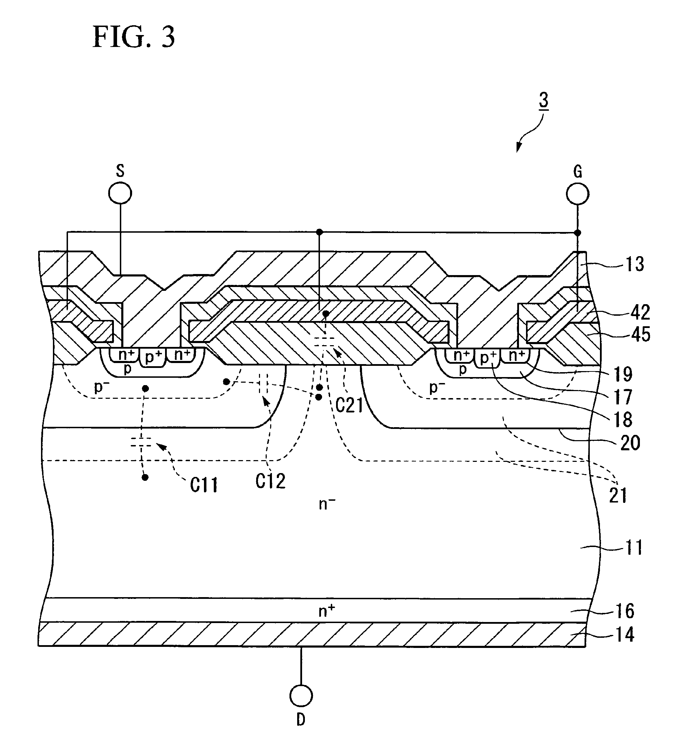

FIG 3 is a cross-sectional view showing a schematic configuration of a semiconductor device according to a third embodiment of the invention. As shown in FIG 3, a semiconductor device 3 according to this embodiment differs in that, instead of the gate electrode 12 and the oxide film 15 shown in FIG 1, it includes a gate electrode 42 and an oxide film 45 which have different structures thereto. The semiconductor device 3 of this embodiment includes an oxide film 45 made by local oxidation of silicon (LOCOS), and a gate electrode 42 that is formed on the oxide film 45.

As shown in FIG. 3, the oxide film 45 is formed so as to be embedded in the substrate where the n-drift layer 11 and the like are formed between p base layers 17. The oxide film 45 electrically isolates the p base layers 17 from each other. For example, SiO₂ can be used as the oxide film 45. Since the oxide film 45 is formed by embedding, as shown in FIG 3, it is thick. The gate electrode 42 is formed from, for example, polysilicon. The length of the gate electrode 42 is the length from the n⁺ layer 19 formed on one of adjacent p base layers 17, via the top of the embedded oxide film 45 to the n⁺ layer 19 formed on the other p base layer 17. The oxide film 45 is formed not only below the gate electrode 42, but also such as to surround it.

In this embodiment, the gate electrode 42 is formed on the thick oxide film 45. Therefore, the distance between the gate electrode 42 and the n⁻ drift layer 11 can be increased. This can reduce the capacitance C21 via the oxide film 45 between the n⁻ drift layer 11 the gate electrode 42. As a result, the drain-gate capacitance C_{dg} can be greatly reduced. Furthermore in this embodiment, as in the first embodiment, since the extended p base layer 20 is formed around the p base layer 17, the drain-source capacitance C_{ds} is also greatly reduced. Thus in this embodiment, both the drain-gate capacitance C_{dg} and the drain-source capacitance C_{ds} can be greatly reduced, thereby greatly reducing the parasitic capacitance.

As in the semiconductor device 1 of the first embodiment, in the semiconductor device 3 of this embodiment, the gate electrode 12 is longer than the source electrode. It is therefore appropriate for use as a high breakdown voltage device in which an increase in the length of the gate electrode 12 does not greatly affect the on-resistance.

While the foregoing examples describe embodiments where the p base layer 17 and the extended p base layer 20 are formed using an n-type silicon substrate, the invention can also be applied in a case where an n base layer and an extended n base layer are formed using a p-type silicon substrate.

### (Fourth Embodiment)

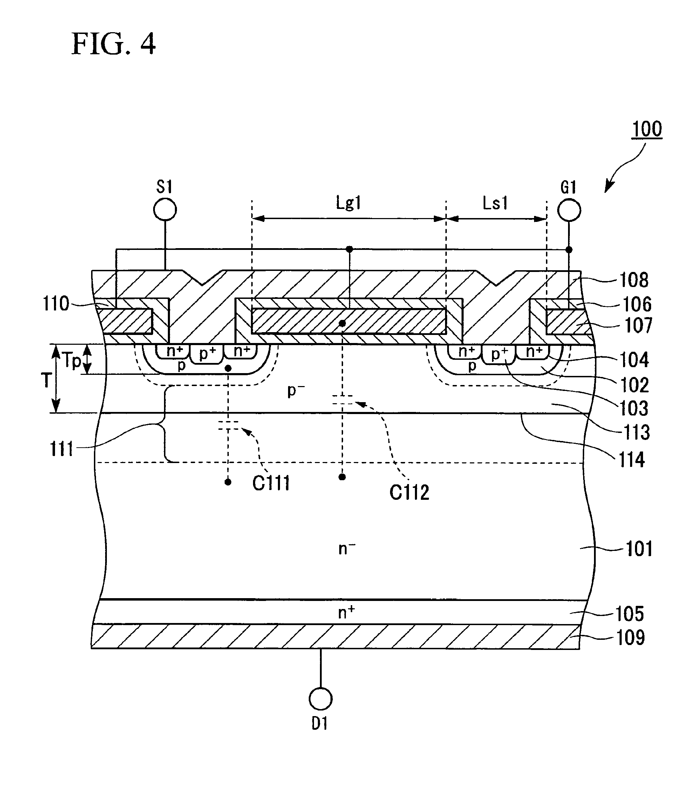

A fourth embodiment according to the invention will be explained with reference to FIG. 4. FIG. 4 is a cross-sectional view showing a schematic configuration of an n-channel vertical double-diffused MOSFET (hereinafter referred as "a semiconductor device") 100 according to a fourth embodiment.

The semiconductor device 100 shown in FIG 4 includes an extended p base layer (extended second region) 113.

In FIG.4, symbols 'n,' 'p,' '+,' and '-' have the same meanings as the symbols shown in FIG 1.

The semiconductor device 100 includes a source terminal S1, a gate terminal G1, and a drain terminal D 1. An n⁻ drift layer (first region) 101 forms a substrate and is n-conductive. An n⁺ layer 105 and a drain electrode 109 are formed on one face of the n⁻ drift layer 101. The drain electrode 109 is thus adjacent to one face of the n⁻ drift layer 101. A gate electrode 107 and a source electrode 108 are formed on the other face of the n⁻ drift layer 101.

A plurality of the gate electrodes 107 are arranged discretely. The gate electrodes 107 are made of polysilicon and formed in a plate shape. The gate electrodes 107 are covered with an oxide film (insulating substance) 106. A face of each gate electrode 107 is arranged opposite the face of the n⁻ drift layer 101. The gate electrodes 107 are arranged regularly. For example, the gate electrodes 107 are arranged at equal intervals in a lattice formation (not shown).

The source electrode 108 is formed in a single piece such as to cover and the gate electrode 107 and the oxide film 106. The source electrode 108 is formed so as to fill a gap between the gate electrodes 107.

A p base layer (second region) 102 is p-conductive. The gate electrode 107, the oxide film 106, and the source electrode 108 are formed on one face side of the p base layer 102. A plurality of the p base layers 102 are regularly arranged at equal intervals.

A p⁺ layer 103 having a high density of impurities and an n⁺ layer 104 having a high density of impurities are formed on one face of the p base layer 102. The p⁺ layer 103 is formed in a central portion of one face of the p base layer 102, and is adjacent to the source electrode 108. The n⁺ layer 104 is formed such as to surround the p⁺ layer 103, and is surrounded by the p base layer 102. The n⁺ layer 104 is adjacent to the source electrode 108, the gate electrode 107, and the oxide film 106.

The thickness Tp of the p base layer 102 is preferably made thin (shallow), so that it does not hinder the extension of the depletion layer 111 from a PN junction part 114. The length of the p base layer 102 is longer than a gate interval Ls1.

The regular repetition of the gate electrode 107, the source electrode 108, and the p base layer 102 forms repeated units (cells) of the semiconductor device.

An extended p base layer (extended second region) 113 is p-conductive. The extended p base layer 113 is formed between the other face of the n⁻ drift layer 101 and the other face of the p base layer 102. That is, one face of the extended p base layer 113 is adjacent to the other face of the n⁻ drift layer 101, while the other face of the extended p base layer 113 is adjacent to the other face of the p base layer 102, the gate electrode 107, and the oxide film 106.

The PN junction part 114 is formed on a junction face between one face of the extended p base layer 113 and the other face of the n⁻ drift layer 101.

The extended p base layer 113 entirely covers (surrounds) the other face of the p base layer 102. That is, the p-conductive extended p base layer 113 is adjacent to the p base layer 102 whereas the n-conductive region is not. The extended p base layer 113 is adjacent to the gate electrode 107 and the oxide film 106 in a region immediately below a central portion of the gate electrode 107.

The impurity density of the extended p base layer 113 is lower than that of the p base layer 102. The combination of the impurity density of the extended p base layer 113 and its thickness T is set such that, when a voltage below a threshold voltage is applied to the gate electrode 107, characteristics of the extended p base layer 113 are inverted from p-conductive to n-conductive. That is, the impurity density of the extended p base layer 113 is sufficiently low, and the thickness T of the extended p base layer 113 is sufficiently thin.

In FIG 4, the p base layer 102 is formed, for example, by diffusion of impurities into the other face of the extended p base layer 113. That is, in the embodiment shown in FIG 4, the p base layer 102 is formed in portions of the extended p base layer 113. The thickness Tp of the p base layer 102 is sufficiently thinner than the thickness T of the extended p base layer 113.

An end of the gate electrode 107 is adjacent to one face of the p base layer 102. The central portion of the gate electrode 107 is adjacent to the extended p base layer 113. The gate length Lg1 of the gate electrode 107 is longer than the gate interval Ls1, which is the length between the gate electrodes 107.

An operation of the semiconductor device 100 according to the fourth embodiment of the invention shown in FIG 4 will be explained.

When the semiconductor device 100 is in an off-state, a depletion layer 111 is generated near the PN junction part 114. In the semiconductor device 100, since the impurity density of the extended p base layer 113 is sufficiently low, the depletion layer 111 spreads inside the extended p base layer 113. The p base layer 102 and the n⁻ drift layer 101 are partitioned by the wide depletion layer 111. The gate electrode 107 and the oxide film 106, and the n⁻ drift layer 101, are partitioned by the wide depletion layer 111.

Therefore, in the semiconductor device 100, a drain-source capacitance C_{ds} (C111 in FIG. 4) becomes a very small value. Furthermore, in the semiconductor device 100, the drain-gate capacitance C_{dg} (C 112 in FIG. 4) also becomes a very small value.

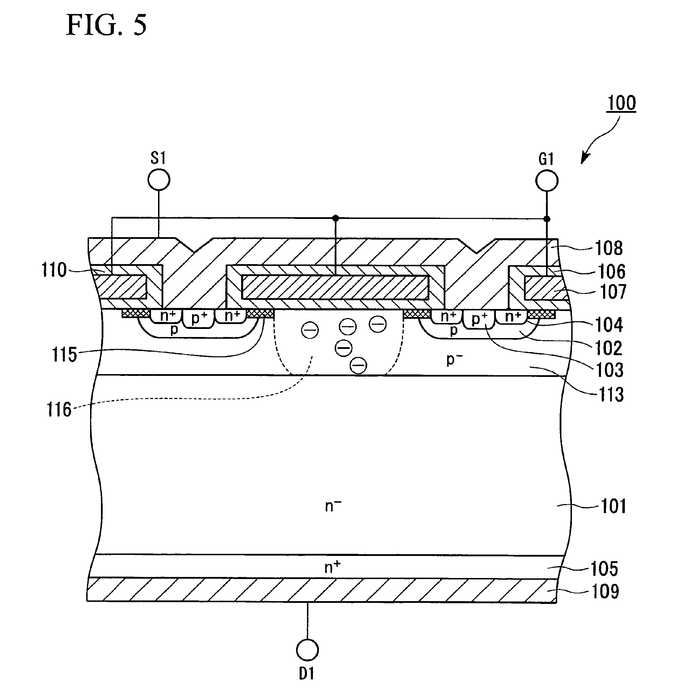

FIG 5 is a cross-sectional view showing the semiconductor device 100 in a conductive state. In FIG 5, constituent elements similar to those in FIG 4 are designated with like reference numerals and are not repetitiously explained.

A voltage exceeding a threshold voltage is applied to the gate electrode 107. At this time, an n-conductive type channel 115 is formed in a region immediately below the gate electrode 107.

The extended p base layer 113 immediately below the gate electrode 107 is inverted from p-conductive to n-conductive, and becomes an inverted region 116. Since the extended p base layer 113 has low impurity density, and the thickness T of the extended p base layer 113 is thin, the inverted region 116 is formed not only on the top face but also in the internal portion. That is, one face of the inverted region 116 is adjacent to the other face of the n⁻ drift layer 101, and the other face of the inverted region 116 is adjacent to the n-conductive type channel 115, the gate electrode 107, and the oxide film 106.

Electrons fill the inverted region 116. As a result, a carrier path is generated across the p base layer 102, the channel 115, the inverted region 116, and the n⁻ drift layer 101, and current flows between the source terminal S1 and the drain terminal D1.

When the gate length Lg1 is short, the inverted region 116 becomes smaller and the resistance of the inverted region 116 increases. When the gate length Lg1 is long, the repeated unit (cell) of the semiconductor device becomes larger, the number of cells per device unit area decreases, and the resistance of the channel 115 increases. Therefore, an ideal gate length Lg1 is determined based on the resistance (on-resistance) between the source electrode S1 and the drain electrode D1.

Due to this, the configuration of the semiconductor device 100 shown in FIG 4 is ideal for a device in which the gate length Lg1 is long, the inverted region 116 is large, the resistance of the inverted region 116 is small, and the resistance of the channel 115 does not affect the bulk resistance. That is, the configuration of the semiconductor device 100 shown in FIG 4 is ideal in, for example, a device with a high breakdown voltage in the 3000 V range.

When the on-resistance and the element breakdown voltage of the semiconductor device 100 shown in FIG. 4 are set such that they are the same as the on-resistance and the element breakdown voltage of the conventional DMOSFET 200 shown in FIG. 11, the drain-source capacitance C_{ds} (C111 in FIG 4) and the drain-gate capacitance C_{dg} (C 112 in FIG. 4) of the semiconductor device 100 are considerably smaller than the drain-source capacitance C_{ds} (C201 and C202 in FIG. 11) and the drain-gate capacitance C_{dg} (C210 in FIG. 11) of the DMOSFET 200 shown in FIG. 11, respectively.

At this time, ideal characteristics are obtained when the gate length Lg1 of the semiconductor device 100 shown in FIG 4 is, for example, more than ten times the gate length Lg2 of the DMOSFET 200 in the conventional example of FIG. 11. In the semiconductor device 100 shown in FIG. 4, the drain-source capacitance C_{ds} and the drain-gate capacitance C_{dg} can both be further reduced by increasing the gate length Lg1.

### (Fifth Embodiment)

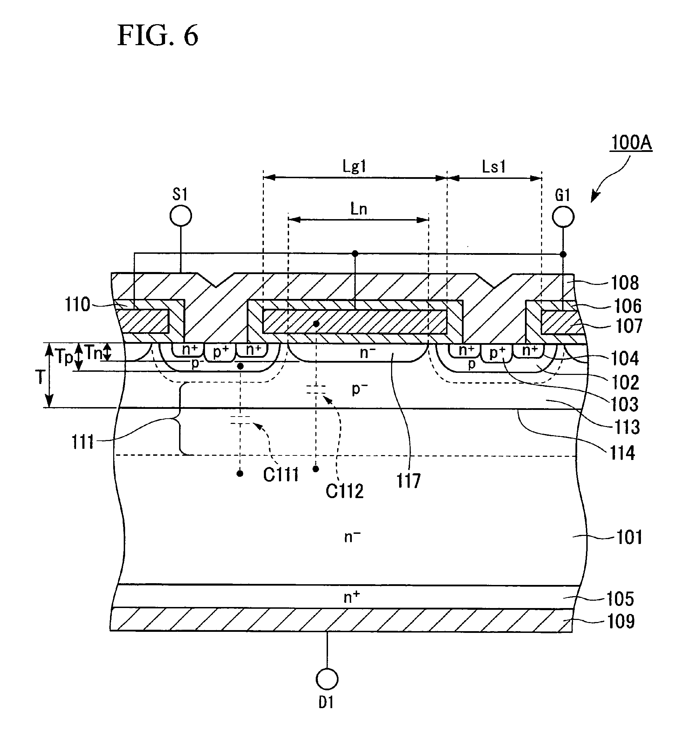

FIG 6 is a cross-sectional view showing an n-channel vertical double-diffused MOSFET (hereinafter referred as "a semiconductor device") 100A according to a fifth embodiment of the invention. In FIG 6, constituent elements similar to those in FIG 4 are designated with like reference numerals and are not repetitiously explained.

The semiconductor device 100A shown in FIG 6 includes an extended p base layer 113, and a below-gate n⁻ layer (fifth region) 117. The below-gate n⁻ layer 117 is formed between the gate electrode 107 and the extended p base layer 113.

Specifically, the below-gate n⁻ layer 117 is formed on the other face (silicon top face) of the extended p base layer 113, and in a region immediately below a central portion of the gate electrode 107. One face of the below-gate n⁻ layer117 is adjacent to the gate electrode 107 with the oxide film 106 in between. The other face of the below-gate n⁻ layer 117 is adjacent to the extended p base layer 113, and is covered by the extended p base layer 113.

The length Ln of the below-gate n⁻ layer 117 is shorter than the gate length Lg1, and longer than the gate interval Ls1. The thickness Tn of the below-gate n⁻ layer 117 is thinner than the thickness Tp of the p base layer 102. The below-gate n⁻ layer 117 is thin and has low impurity-density.

In the below-gate n⁻ layer 117, phosphorus (P) is segregated at the interface of the oxide film 106, and borons (B) have a property of being captured (eaten) by the oxide film 106. Therefore, in a method of manufacturing the semiconductor device 1 00A shown in FIG 4, the silicon top face is formed as n-type, thereby creating the below-gate n⁻ layer 117.

The semiconductor device 100A shown in FIG 6 is easier to manufacture than the semiconductor device 100 shown in FIG 4. Specifically, the density conditions of the extended p base layer 113 of the semiconductor device 100A shown in FIG 6 are broader than those of the extended p base layer 113 of the semiconductor device 100 shown in FIG 4. Strict density control is required to ensure that the below-gate n⁻ layer 117 is not generated.

The below-gate n⁻ layer 117 slightly reduces the on-resistance of the semiconductor device 100A. Moreover, the below-gate n⁻ layer 117 slightly increases the output capacity of the semiconductor device 100A.

The below-gate n⁻ layer 117 does not greatly affect the device characteristics of the semiconductor device 100A shown in FIG 6. Therefore, the device characteristics of the semiconductor device 100A are roughly the same as those of the semiconductor device 100 shown in FIG. 4. Also, effects obtained by using the semiconductor device 100A are almost the same as those obtained by using the semiconductor device 100.

### (Sixth Embodiment)

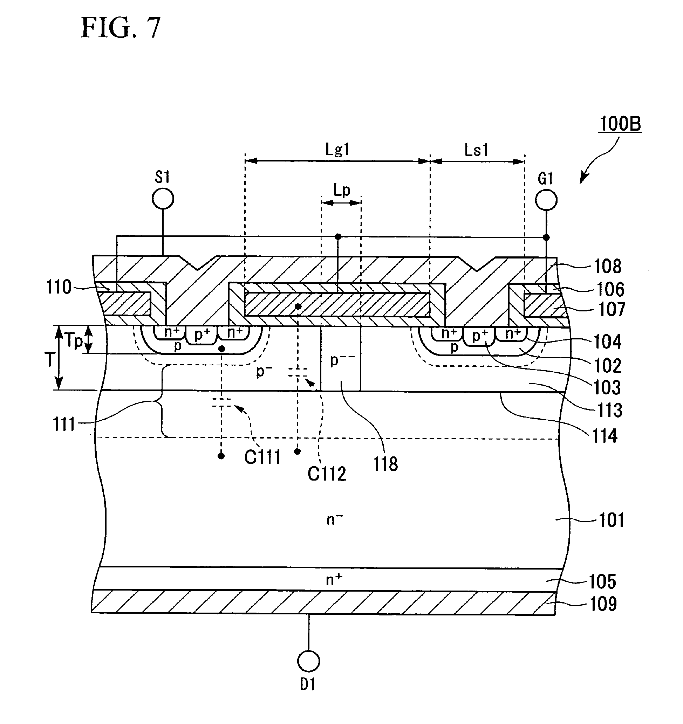

FIG 7 is a cross-sectional view showing an n-channel vertical double-diffused MOSFET (hereinafter referred as "a semiconductor device") 100B according to a sixth embodiment of the invention. Constituent elements similar to those in FIG 4 are designated with like reference numerals and are not repetitiously explained.

The semiconductor device 100B shown in FIG 7 includes an extended p base layer 113 and a p- low-density layer (fourth region) 118.

The p⁻⁻ low-density layer 118 is formed as a p-conductive type. The p⁻⁻ low-density layer 118 is formed immediately below a central portion of the gate electrode 107. Specifically, the p⁻⁻ low-density layer 118 is formed between one p base layer 102 and another p base layer 102 (a portion roughly in the center).

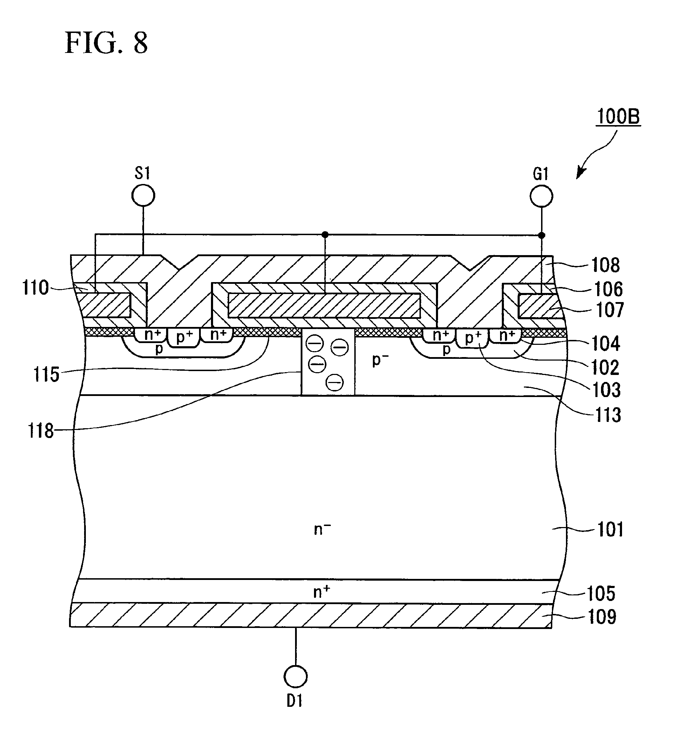

In the semiconductor device 100B shown in FIG 7, the p⁻⁻ low-density layer 118 is formed in a portion of the extended p base layer 113. One face of the p⁻⁻ low-density layer 118 is adjacent to the other face of the n⁻ drift layer 101, and the other face of the p⁻⁻ low-density layer 118 is adjacent to the channel 115, which is shown in FIG 8, the gate electrode 107, and the oxide film 106.

The length Lp of the p⁻⁻ low-density layer 118 is shorter than the gate length Lg1. The thickness T of the p⁻⁻ low-density layer 118 is, for example, the same as the thickness T of the extended p base layer 113.

The impurity density of the p⁻⁻ low-density layer 118 is much lower than that of the extended p base layer 113. The p⁻⁻ low-density layer 118 can be made from, for example, an intrinsic semiconductor. The density of the extended p base layer 113 near the p⁻⁻ low-density layer 118 can be made lower than the density of the extended p base layer 113 near the p base layer 102.

A combination of the impurity density of the p⁻⁻ low-density layer 118 and its thickness T is set such that, when a voltage below a threshold voltage is applied to the gate electrode 107, characteristics of the p⁻⁻ low-density layer 118 are inverted from p-conductive to n-conductive. That is, the impurity density of the p⁻⁻ low-density layer 118 is sufficiently low, and its thickness T is sufficiently thin.

An operation of the semiconductor device 100B shown in FIG 7 will be explained.

When the semiconductor device 100B is in an off-state, as when the semiconductor device 100 shown in FIG 4 is in an off-state, the p base layer 102 and the n⁻ drift layer 101 are partitioned by the wide depletion layer 111.

Consequently, the drain-source capacitance C_{ds} (C111) of the semiconductor device 100B shown in FIG 7 has a very small value. Also, the drain-gate capacitance C_{dg} (C112) of the semiconductor device 100B has a very small value.

FIG 8 is a cross-sectional view showing the semiconductor device 100B in a conductive state. Constituent elements similar to those in FIG 7 are designated with like reference numerals and are not repetitiously explained.

A voltage greater than the threshold voltage is applied to the gate electrode 107. At this time, the n-conductive type channel 115 is formed in a region immediately below the gate electrode 107.

Moreover, the entire p⁻⁻ low-density layer 118 is inverted from p-conductive to n-conductive. Electrons fill the p⁻⁻ low-density layer 118. This generates a carrier path across the p base layer 102, the channel 115, the p⁻⁻ low-density layer 118, and the n⁻ drift layer 101, whereby current flows between the source terminal S 1 and the drain terminal D1.

Therefore, the operation of the semiconductor device 100B shown in FIG. 7 is similar to that of the semiconductor device 100 shown in FIG 4. Effects obtained by using the semiconductor device 100B are also similar to those obtained by using the semiconductor device 100.

A method of manufacturing the semiconductor device 100B shown in FIG 7 will be explained.

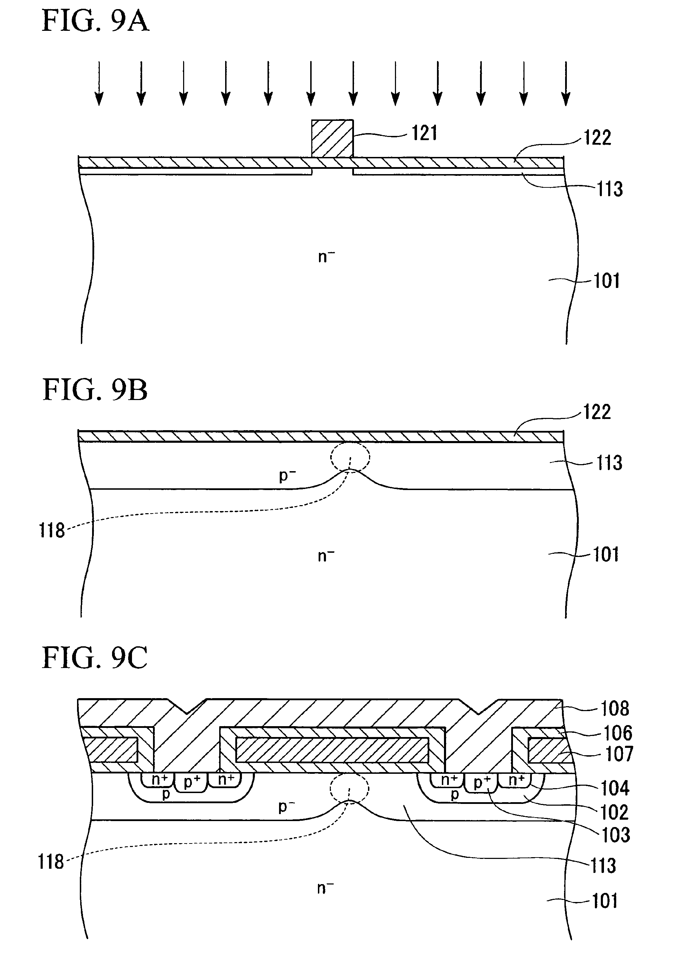

FIGS. 9A to 9C are step diagrams showing a method of manufacturing the semiconductor device 100B shown in FIG 7. Constituent elements similar to those in FIG 7 are designated with like reference numerals and are not repetitiously explained.

Firstly, an n⁻ drift layer 101 which is an n-conductive substrate is formed (not shown). An oxide film 122 is formed the entire other face of the n⁻ drift layer 101 (not shown).

Next, a resist 121 is formed over one portion of the other face of the n⁻ drift layer 101 (not shown). The formation of this resist 121 relates to the shape of a p⁻⁻ low-density layer.

Next, ions are injected from the top face side of the resist 121, forming an extended p base layer 113.

FIG. 9A illustrates this ion-injection step. One face of the extended p base layer 113 is formed on the other face of the n⁻ drift layer 101. Since a region immediately below the resist 121 is not implanted with ions, no extended p base layer 113 is formed there.

The resist 121 is then removed.

Next, a p⁻⁻ low-density region 118 is formed in a portion immediately below the region which the resist 121 was removed from. By performing diffusion, the extended p base layers 113 are connected to each other, and the p⁻⁻ low-density region 118 is formed.

FIG 9B illustrates steps of removing the resist 121 and forming the p⁻⁻ low-density region 118.

Lastly, a p-conductive p base layer 102 (not shown) is formed on another face of the extended p base layer 113. At this time, the impurity density of the p base layer 102 is made higher than that of the extended p base layer 113. Next, a gate electrode 107 and a source electrode 108 are formed. A drain electrode 109 is also formed (not shown).

FIG. 9C illustrates a step of forming the gate electrode 107 and the source electrode 108. This last step is similar to a step of manufacturing a conventional vertical DMOSFET.

### (Seventh Embodiment)

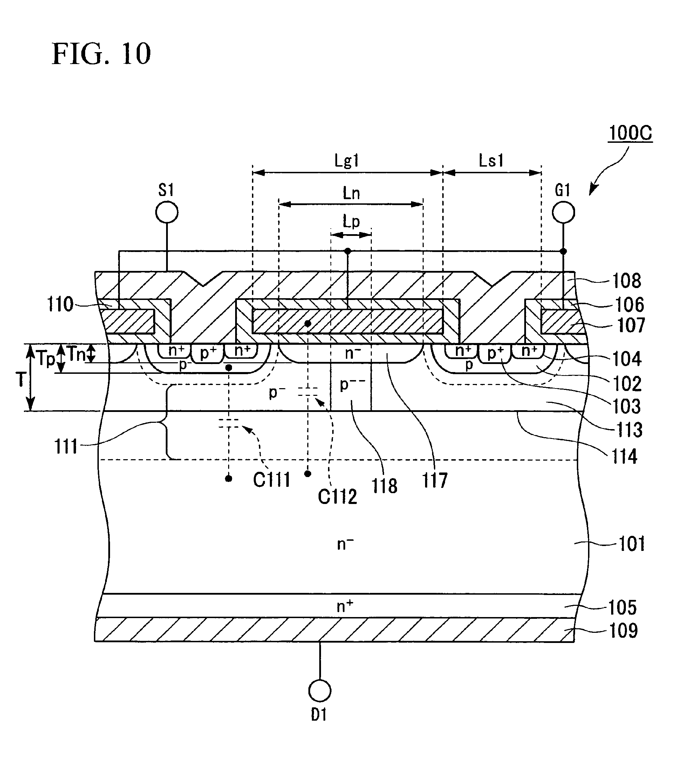

FIG 10 is a cross-sectional view showing an n-channel vertical double-diffused MOSFET (hereinafter referred as "a semiconductor device") 100C according to a seventh embodiment of the invention. Constituent elements that are similar to those of the semiconductor device 100B shown in FIG 7 are designated with like reference codes, and are not repetitiously explained.

The semiconductor device 100C shown in FIG 10 includes a below-gate n⁻ layer 117. The correspondence relationship between the semiconductor device 100C shown in FIG 10 and the semiconductor device 100B shown in FIG 7 is the same as that between the semiconductor device 100A shown in FIG 6 and the semiconductor device 100 shown in FIG 4.

The below-gate n⁻ layer 117 is formed between the gate electrode 107 and the extended p base layer 113. Further, the below-gate n⁻ layer 117 is formed between the gate electrode 107 and the p⁻⁻ low-density region 118.

More specifically, the below-gate n⁻ layer 117 is formed on the other face (silicon face) of the extended p base layer 113, in a region that is immediately below a central portion of the gate electrode 107. One face of the below-gate n⁻ layer 117 is adjacent to the gate electrode 107 with the oxide film 106 therebetween. The other face of the below-gate n⁻ layer 117 is adjacent to the extended p base layer 113 and the p⁻⁻ low-density region 118.

The length Ln of the below-gate n⁻ layer 117 is shorter than the gate length Lg1, longer than the gate interval Ls1, and longer than the length Lp of the p⁻⁻ low-density region 118. The thickness Tn of the below-gate n⁻ layer 117 is thinner than the thickness Tp of the p base layer 102. The below-gate n⁻ layer 117 is thin and has low impurity density.

The semiconductor device 100C can be manufactured more easily than the semiconductor device 100B. Specifically, the density conditions of the extended p base layer 113 for manufacturing the semiconductor device 100C are wider than those of the extended p base layer 113 for manufacturing the semiconductor device 100B.

Furthermore, the below-gate n⁻ layer 117 in the semiconductor device 100C shown in FIG 10, like the below-gate n⁻ layer 117 in the semiconductor device 100A shown in FIG 6, slightly reduces the on-resistance of the semiconductor device. The below-gate n⁻ layer 117 also slightly increases the output capacity of the semiconductor device.

The below-gate n⁻ layer 117 does not greatly affect the device characteristics of the semiconductor device 100C shown in FIG 10. Therefore, the device characteristics of the semiconductor device 100C are roughly the same as the device characteristics of the semiconductor device 100B. Effects obtained by using the semiconductor device 100C are roughly the same as those obtained by using the semiconductor device 100B.

A configuration according to the invention can be applied not only in an n-type MOSFET, but also in a p-type MOSFET. Specifically, even if in a semiconductor device according to the embodiments of the invention shown in FIGS. 4 to 10, a portion having n-type is reversed to p-type and vice versa, the device has a similar configuration and similar effects can be obtained by using it.

A configuration according to the invention can also be applied in an element other than a vertical MOSFET. Specifically, it can be applied in an insulated gate bipolar transistor (IGBT) and similar effects can be obtained by using it.

The invention is not limited to a semiconductor made of silicon. A configuration according to the invention can be applied in a semiconductor of other than silicon, and similar effects can be obtained by using it.

In the semiconductor device shown in FIG. 4 and FIG 6, instead of the other face of the n⁻ drift layer 101 being entirely covered by the extended p base layer 113, a plurality of extended p base layers 113 can be formed in division, as in the structure shown in FIG 9A.

While preferred embodiments of the invention have been described and illustrated above, it should be understood that these are exemplary of the invention and are not to be considered as limiting. Additions, omissions, substitutions, and other modifications can be made without departing from the spirit or scope of the present invention. Accordingly, the invention is not to be considered as being limited by the foregoing description, and is only limited by the scope of the appended claims.

## Claims

1. A semiconductor device comprising:
a first region having a first conductive type;
a plurality of second regions having a second conductive type that differs from the first conductive type and formed to be arranged in the first region;
a plurality of third regions having the first conductive type and formed in the second regions;
an electrode forming a channel between the first region and the third region; and
a plurality of extended second regions having the second conductive type, arranged in the first region such as to individually include one of the second regions and having an impurity density that is lower than an impunity density of the second regions.

2. The semiconductor device according to claim 1, wherein
an oxide film is formed between the second regions and isolates adjacent second regions; and
the electrode is provided from the third region formed in one of adjacent second regions to the third region formed in other of the adjacent second regions, with the oxide film therebetween.

3. The semiconductor device according to claim 1, wherein each of a plurality of the electrodes corresponds with each of the third regions and is formed only near each of the third regions.

4. A semiconductor device comprising:
a first region having one face provided adjacently to a drain electrode;
a plurality of gate electrodes formed discretely with each other;
a source electrode covering the gate electrodes;
a second region having one face provided adjacently to the gate electrode and the source electrode; and
an extended second region formed between other face of the first region and other face of the second region and having an impunity density that is lower than an impunity density of the second region.

5. The semiconductor device according to claim 4, wherein:
an end part of the gate electrode is provided adjacently to the one face of the second region, a central portion of the gate electrode is provided adjacently to the extended second region, a gate length of the gate electrode is longer than an gate interval between the gate electrodes, and the gate electrode is formed in a plate-like shape and is covered with an oxide film;
a thickness of the extended second region is set such that an inversion region that inverts from the second conductive type to the first conductive type is generated in the extended second region when a voltage below a threshold voltage is applied;
the second region is formed on other face of the extended second region, and a thickness of the second region is thinner than the thickness of the extended second region.

6. The semiconductor device according to claim 4, further comprising a fourth region formed immediately below the gate electrode and having an impunity density that is lower than the impunity density of the extended second region.

7. The semiconductor device according to claim 4, further comprising a fifth region formed between the gate electrode and the extended second region.
